(19) Europäisches Patentamt
European Patent Office
Office européen des brevets

(11) **EP 4 502 587 A1**

(12) **EUROPEAN PATENT APPLICATION**
published in accordance with Art. 153(4) EPC

(43) Date of publication:
**05.02.2025 Bulletin 2025/06**

(21) Application number: **23780666.6**

(22) Date of filing: **29.03.2023**

(51) International Patent Classification (IPC):
**G01N 27/30** (2006.01)     **C23C 14/06** (2006.01)

(52) Cooperative Patent Classification (CPC):
**C23C 14/06; G01N 27/30**

(86) International application number:
**PCT/JP2023/012755**

(87) International publication number:
**WO 2023/190657 (05.10.2023 Gazette 2023/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **31.03.2022 JP 2022059340**

(71) Applicant: **Nitto Denko Corporation**
**Ibaraki-shi**
**Osaka 567-8680 (JP)**

(72) Inventors:
• **UEDA, Eri**
**Ibaraki-shi, Osaka 567-8680 (JP)**
• **WATANABE, Yuna**
**Ibaraki-shi, Osaka 567-8680 (JP)**
• **HAISHI, Motoki**
**Ibaraki-shi, Osaka 567-8680 (JP)**

(74) Representative: **Gill Jennings & Every LLP**
**The Broadgate Tower**
**20 Primrose Street**
**London EC2A 2ES (GB)**

(54) **ELECTRODE, AND ELECTROCHEMICAL MEASURING SYSTEM**

(57) An electrode (1) includes a substrate film (2), a metal underlying layer (3), and a conductive carbon layer (4) in sequence toward one side in the thickness direction. In the metal underlying layer (3), the ratio R of oxygen is 32% or less in terms of atom and obtained by the following formular [1].

$$R = 100 \times [X_1/(X_0+X_1)] \quad [1]$$

$X_1$: the atomic ratio (atomic%) of the oxygen in the metal underlying layer 3
$X_0$: the atomic ratio (atomic%) of the metal material in the metal underlying layer 3

FIG. 1

EP 4 502 587 A1

**Description**

TECHNICAL FIELD

The present invention relates to an electrode and an electrochemical measurement system.

BACKGROUND ART

There is a known electrode including a substrate film, a metal underlying layer, and a conductive carbon layer in sequence toward one side in the thickness direction (for example, see Patent Document 1 below). In the electrode of Patent Document 1, the metal underlying layer functions as an adhesive layer.
The metal underlying layer described in Patent Document 1 is formed on a one-side surface of the substrate film using sputtering. In the sputtering, the pressure in the sputtering chamber is reduced, and thereafter a sputtering gas is introduced into the sputtering chamber.

Citation List

Patent Document

Patent Document 1: Japanese Unexamined Patent Publication No. 2019-105637

SUMMARY OF THE INVENTION

PROBLEM TO BE SOLVED BY THE INVENTION

Electrodes are required to have more excellent adhesiveness. Adhesiveness is a property of a conductive carbon layer not to easily be peeled from the substrate film. When the adhesiveness is excellent, the conductive carbon layer has a high adhesive strength to the substrate film.
However, there are limits on the electrode described in Patent Document 1 to improve the adhesiveness.
The present invention provides an electrode and an electrochemical measurement system in which the conductive carbon layer has an excellent adhesiveness to the substrate film.

MEANS FOR SOLVING THE PROBLEM

The present invention [1] includes an electrode including: a substrate film; a metal underlying layer; and a conductive carbon layer in sequence toward one side in a thickness direction, wherein a ratio R of oxygen in the metal underlying layer is 32% or less in terms of atom, and obtained by the following formula (1).

$$R = 100 \times [X_1/(X_0+X_1)] \quad (1)$$

$X_1$: The atomic ratio (atomic%) of the oxygen in the metal underlying layer
$X_0$: The atomic ratio (atomic%) of the metal material in the metal underlying layer

The present invention [2] includes the electrode described in the above-described [1], wherein the metal material in the metal underlying layer includes at least one metal selected from the group consisting of titanium, chromium, tungsten, aluminum, silicon, niobium, molybdenum, tantalum, and copper.
The present invention [3] includes the electrode described in the above-described [1] or [2], wherein the substrate film is a polymer film.
The present invention [4] includes the electrode described in any one of the above-described [1] to [3], wherein the conductive carbon layer includes an $sp^2$-bonded atom and an $sp^3$-bonded atom.
The present invention [5] includes the electrode described in any one of the above-described [1] to [4], being an electrode for an electrochemical measurement.
The present invention [6] includes an electrochemical measurement system including: the electrode described in the above-described [5].

EFFECTS OF THE INVENTION

In the electrode and the electrochemical measurement system of the present invention, the conductive carbon layer has excellent adhesiveness to the substrate film.

BRIEF DESCRIPTION OF THE DRAWINGS

FIG. 1 is a cross-sectional view of one embodiment of the electrode of the present invention.
FIG. 2 is a view describing a method of evaluating the adhesiveness of Example.

DESCRIPTION OF THE EMBODIMENT

1. Electrode 1

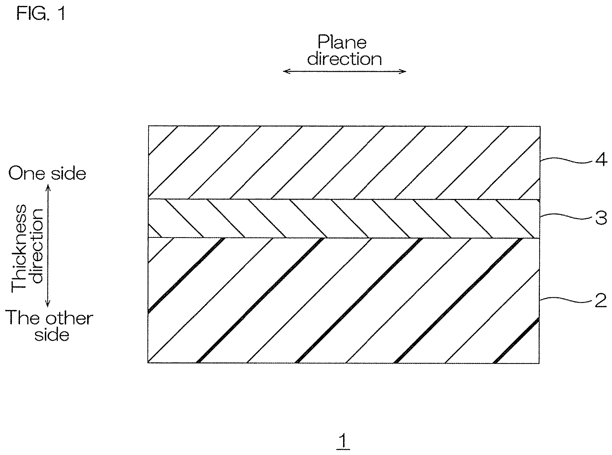

One embodiment of the electrode of the present invention is described with reference to FIG. 1.
An electrode 1 has a thickness. The electrode 1 extends in a plane direction. The plane direction is perpendicular to a thickness direction. The electrode 1 has the shape of a film. The electrode 1 includes a substrate film 2, a metal underlying layer 3, and a conductive carbon layer 4 in sequence toward one side in the thickness direction.

1.1 Substrate Film 2

The substrate film 2 is disposed on the other end portion of the electrode 1 in the thickness direction. The substrate film 2 forms the other-side surface of the electrode 1 in the thickness direction. The substrate film 2 extends in the plane direction.
The substrate film 2 has the shape of a film. Examples of the material of the substrate film 2 include an inorganic material and an organic material. Examples of the inorganic material include silicon and glass. Examples of the organic material include a polymer material. Examples of the polymer material include polyester, polyolefin, acryl, and polycarbonate. Examples of the polyester include polyethylene terephthalate (PET) and polyethylene naphthalate. As the material of the substrate film 2, preferably, an organic material is used, more preferably, polyester is used, even more preferably, PET is used. When the material of the substrate film 2 is a polymer material, the substrate film 2 is a polymer film. The polymer film has flexibility. The substrate film 2 has a thickness of, for example, 2 $\mu$m or more, preferably 20 $\mu$m or more, and, for example, 1000 $\mu$m or less, preferably 500 $\mu$m or less.

1.2 Metal Underlying Layer 3

The metal underlying layer 3 is disposed on a one-side surface of the substrate film 2 in the thickness direction. Specifically, the metal underlying layer 3 is in contact with the one-side surface of the substrate film 2 in the thickness direction. The metal underlying layer 3 is an intermediate layer of the electrode 1 in the thickness direction. The metal underlying layer 3 extends in the plane direction. The metal underlying layer 3 is an adhesive layer. The adhesive layer improves the adhesiveness of the conductive carbon layer 4, which is described next, to the substrate film 2.
The ratio R of the oxygen in the metal underlying layer 3 is 32% or less in terms of atom.
When the ratio R of the oxygen in the metal underlying layer 3 is more than 32% in terms of atom, the conductive carbon layer 4 cannot have a good adhesive force to the substrate film 2.
The ratio R of the oxygen in the metal underlying layer 3 is preferably 30% or less, more preferably 28% or less, even more preferably 25% or less, particularly preferably 20% or less, the most preferably 15% or less in terms of atom. When the ratio R of the oxygen in the metal underlying layer 3 is the above-described upper limit or less, the conductive carbon layer 4 can have a better adhesive force to the substrate film 2.
The lower limit of the ratio R of the oxygen in terms of atom is not limited. The ratio R of the oxygen in the metal underlying layer 3 in terms of atom is, for example, 0% or more, and in view of increasing the manufacturing efficiency, preferably more than 0%, more preferably 3% or more, even more preferably 5% or more, particularly preferably 8% or more, the most preferably 10% or more.
The ratio R of the oxygen in the metal underlying layer 3 can be obtained using the depth analysis in an X-ray Electron Spectroscopy for Chemical Analysis (ESCA). Specifically, in the depth analysis, in the depth at a peak derived from the metal material of the metal underlying layer 3 (a point at which the atomic ratio of the metal material is the highest), each of the atomic ratio $X_0$ (atomic%) of the metal material in the metal underlying layer 3 and the atomic ratio $X_1$ (atomic%) of the oxygen in the metal underlying layer 3 is obtained and substituted into the following formula (1).

$$R = 100 \times [X_1/(X_0+X_1)] \quad (1)$$

In the formula (1), $X_1$ and $X_0$ represent the following.

$X_1$: the atomic ratio (atomic%) of the oxygen in the metal underlying layer 3
$X_0$: the atomic ratio (atomic%) of the metal material in the metal underlying layer 3

Particularly, when the metal material of the metal underlying layer 3 is titanium (described below), $X_0$ is the atomic ratio (atomic%) of the titanium in the metal underlying layer 3.

When the metal material of the metal underlying layer 3 is niobium (described below), $X_0$ is the atomic ratio (atomic%) of the niobium in the metal underlying layer 3.

When the metal underlying layer 3 consists of two types or more of metal materials (an alloy), the above-described ratio R of the oxygen is obtained at the above-described point that is a combined peak of the two types or more of metal materials.

The method of setting the ratio R of the oxygen to the above-described upper limit (32% or less) is not limited. For example, an achieved degree of vacuum in the sputtering described below is set to a predetermined pressure.

The material of the metal underlying layer 3 is a metal material. Examples of the metal material include titanium, chromium, tungsten, aluminum, silicon, niobium, molybdenum, tantalum, and copper. The metal material may be, for example, an alloy of the above. In other words, the metal material includes at least one metal selected from the group consisting of titanium, chromium, tungsten, aluminum, silicon, niobium, molybdenum, tantalum, and copper. As the metal material, in view of the adhesiveness, preferably, titanium and niobium are used.

The metal underlying layer 3 has a thickness of, for example, 1 nm or more, preferably 5 nm or more, more preferably 10 nm or more, even more preferably 12 nm or more, and, for example, 50 nm or less, preferably 30 nm or less, more preferably 20 nm or less.

1.3 Conductive Carbon Layer 4

The conductive carbon layer 4 is disposed at one end portion of the electrode 1 in the thickness direction. The conductive carbon layer 4 is disposed on a one-side surface of the metal underlying layer 3 in the thickness direction. The conductive carbon layer 4 is in contact with the one-side surface of the metal underlying layer 3 in the thickness direction. The conductive carbon layer 4 is disposed at an opposite side to the substrate film 2 with respect to the metal underlying layer 3. The conductive carbon layer 4 forms a one-side surface of the electrode 1 in the thickness direction. The conductive carbon layer 4 extends in the plane direction.

In the present embodiment, the conductive carbon layer 4 includes an $sp^2$-bonded atom and an $sp^3$-bonded atom. Specifically, the conductive carbon layer 4 includes a carbon having an $sp^2$ bond and a carbon having an $sp^3$ bond. In other words, the conductive carbon layer 4 is a layer having a graphite structure and a diamond structure.

Furthermore, the conductive carbon layer 4 is allowed to contain a trace of inevitable impurities other than oxygen.

The conductive carbon layer 4 has a thickness of, for example, 2 nm or more, preferably 10 nm or more, more preferably 20 nm or more, and, for example, 100 nm or less, preferably 50 nm or less, more preferably 40 nm or less. The ratio of the thickness of the conductive carbon layer 4 to the thickness of the metal underlying layer 3 is, for example, 0.5 or more, preferably 1.0 or more, more preferably 1.5 or more, and, for example, 10 or less, preferably 5 or less, more preferably 3 or less, even more preferably 2.5 or less.

1.4 Method of Producing Electrode 1

A method of producing the electrode 1 is described next.

1.4.1 Preparation of Substrate Film 2

First, a substrate film 2 is prepared.

1.4.2 Formation of Metal Underlying Layer 3 and Conductive Carbon Layer 4

Next, the metal underlying layer 3 is formed on the one-side surface of the substrate film 2 in the thickness direction. Subsequently, the conductive carbon layer 4 is formed on the one-side surface of the metal underlying layer 3 in the thickness direction.

Examples of the method of forming each of the metal underlying layer 3 and the conductive carbon layer 4 include a dry method and a wet method. Preferably, the dry method is used. Examples of the dry method include PVD (physical vapor deposition) and CVD (chemical vapor deposition). Preferably, PVD is used. Examples of PVD include sputtering, vacuum deposition, laser deposition, and ion plating. Preferably, sputtering is used. Examples of the sputtering include magnetron sputtering, high-power pulsed sputtering, electron cyclotron resonance sputtering, unbalanced magnetron sputtering, and ion beam sputtering.

The method of forming the metal underlying layer 3 and the method of forming the conductive carbon layer 4 may be the same or different. In the present embodiment, preferably, the method of forming the metal underlying layer 3 and the method of forming the conductive carbon layer 4 are the same. When the method of forming the metal underlying layer 3 and the method of forming the conductive carbon layer 4 are the same, the metal underlying layer 3 and the conductive carbon layer 4 can be formed, for example, by using a common apparatus (specifically, a sputtering apparatus). In the present embodiment, the metal underlying layer 3 and the conductive carbon layer 4 are formed by using a common apparatus.

1.4.2.1 Formation of Metal Underlying Layer 3 and Conductive Carbon Layer 4 by Using Common Sputtering Apparatus

Next, a method of forming a metal underlying layer 3 and a conductive carbon layer 4 in sequence on the substrate film 2 by using a common sputtering apparatus.

1.4.2.2 Structure of Sputtering Apparatus

The sputtering apparatus can form a metal underlying layer 3 and a conductive carbon layer 4 in sequence on the substrate film 2 by sputtering. Although not shown, the sputtering apparatus include a sputtering chamber, a film deposition plate, a decompression unit, a gas supplying unit, and a first target and a second target. Furthermore, the sputtering apparatus may include a magnet.

1.4.2.3 Film Deposition Plate

On a surface of the film deposition plate, the substrate film 2 can be disposed.

1.4.2.4 Decompression Unit

The decompression unit is disposed in the sputtering chamber. The decompression unit can reduce the pressure in the sputtering chamber to an achieved degree of vacuum described next.

1.4.2.5 Gas Supplying Unit

The gas supplying unit is disposed in the sputtering chamber. The decompression unit can supply a sputtering gas into the sputtering chamber. Examples of the sputtering gas include a noble gas. Examples of the noble gas include argon.

1.4.2.6 First Target

The first target is disposed in the sputtering chamber. The first target is disposed therein while facing the film deposition plate at an interval. The first target can function as a cathode.

The first target is electrically connected with a power source. The material of the first target is the metal material of the above-described metal underlying layer 3, and preferably, titanium and niobium are used.

1.4.2.7 Second Target

The second target is disposed in the sputtering chamber. The second target is disposed therein while facing the film deposition plate at an interval. The second target is aligned with the first target. The second target functions as a cathode. The second target is electrically connected with the power source. The material of the second target is carbon (or sintered carbon).

### 1.4.2.8 Magnet

The magnet is disposed at an opposite side to the film deposition plate with respect to the target. When the magnet is included in the sputtering apparatus, the sputtering apparatus can carry out magnetron sputtering.

### 1.4.2.9 Achieved Degree of Vacuum

In the sputtering using the above-described sputtering apparatus, first, the substrate film 2 is disposed on the film deposition plate. Thereafter, by driving the decompression unit, the sputtering chamber is put into a vacuum. The pressure at the time is referred to as an achieved degree of vacuum. The achieved degree of vacuum is also the pressure in the sputtering chamber immediately before the sputtering gas is supplied into the sputtering chamber.

The achieved degree of vacuum is, for example, $2.0 \times 10^{-3}$ Pa or less, preferably less than $2.0 \times 10^{-3}$ Pa, more preferably $1.9 \times 10^{-3}$ Pa or less, even more preferably $1.7 \times 10^{-3}$ Pa or less, particularly preferably $1.5 \times 10^{-3}$ Pa or less, the most preferably $1.010 \times 1^{-3}$ Pa or less. Furthermore, $0.5 \times 10^{-3}$ Pa or less, $0.4 \times 10^{-3}$ Pa or less, $0.3 \times 10^{-3}$ Pa or less are preferable. When the achieved degree of vacuum is the above-described upper limit or less, at least the moisture of the sputtering chamber is efficiently removed. Thereby, the mixing of the oxygen due to the above-described moisture into the metal underlying layer 3 can be suppressed.

The achieved degree of vacuum is, for example, more than $0.00 \times 10^{-3}$ Pa, preferably $0.01 \times 10^{-3}$ Pa or more, more preferably $0.1 \times 10^{-3}$ Pa or more, even more preferably $0.2 \times 10^{-3}$ Pa or less. When the achieved degree of vacuum is the above-described upper limit or less, the vacuum arrival time (described below) from the start of the depressurization of the sputtering chamber can be shortened. Thus, the manufacturing efficiency can be increased.

### 1.4.2.9 Vacuum Arrival Time

The time until the achieved degree of vacuum is reached (the vacuum arrival time) is, for example, 12 hours or less, preferably 6 hours or less, more preferably 3 hours or less, even more preferably 2 hours or less. When the vacuum arrival time is the above-described lower limit or less, the manufacturing efficiency can be increased.

The lower limit of the vacuum arrival time is not limited. The vacuum arrival time is, for example, 1 hour or more, preferably 2 hours or more.

### 1.4.2.10 Formation of Metal Underlying Layer 3

While a sputtering gas is supplied from the gas supplying unit to the sputtering chamber, the electric power is applied to the first target.

When a sputtering gas is supplied from the gas supplying unit to the sputtering chamber, the pressure in the sputtering chamber increases from the above-described achieved degree of vacuum. In other words, the degree of vacuum decreases. As compared with the pressure in the sputtering chamber at the time, the achieved degree of vacuum is extremely low. Thus, the pressure in the sputtering chamber substantially corresponds to the pressure of the sputtering gas supplied from the gas supplying unit.

The pressure of the sputtering gas in the sputtering chamber is not limited. The pressure of the sputtering gas in the sputtering chamber is, for example, less than 0.6 Pa, preferably 0.5 Pa or less, more preferably 0.4 Pa or less, even more preferably 0.3 Pa or less. The pressure of the sputtering gas is, for example, 0.01 Pa or more, preferably 0.05 Pa or more, more preferably 0.1 Pa or more.

The electric power is applied to the first target. When the sputtering is magnetron sputtering, the output applied to the first target is, for example, 1 W/cm$^2$ or more, 2 W/cm$^2$ or more, and, for example, 15 W/cm$^2$ or less, preferably 10 W/cm$^2$ or less.

At the time, the electric power is not applied to the second target.

In this manner, the cation of the noble gas collides with the first target. Then, the molecules of the metal material of the first target scatter from the first target and adhere onto the one-side surface of the substrate film 2.

In this manner, the metal underlying layer 3 is formed on the one-side surface of the substrate film 2 in the thickness direction.

Before the metal underlying layer 3 is formed by sputtering, pre-sputtering can be carried out to wash the surface of the target. At the time, in addition, the surface of the target for forming the conductive carbon layer 4 can also be washed. The substrate film 2 used in the pre-sputtering is not included in the electrode 1 as a product. Such a substrate film 2 is disposable.

1.4.2.11 Formation of Conductive Carbon Layer 4

Next, the electric power is applied to the second target. At the time, the electric power is not applied to the first target.

The pressure of the sputtering gas at the formation of the conductive carbon layer 4 by sputtering is not limited. The pressure of the sputtering gas is, for example, 1 Pa or less, preferably 0.8 Pa or less, more preferably 0.7 Pa or less. The pressure of the sputtering gas is, for example, 0.1 Pa or more, preferably 0.3 Pa or more, more preferably 0.4 Pa or more.

In this manner, the cation of the noble gas collides with the second target. Then, the molecules of the material (carbon) of the second target scatter from the second target and adhere onto one-side surface of the metal underlying layer 3.

In this manner, the conductive carbon layer 4 is formed on the one-side surface of the metal underlying layer 3 in the thickness direction. In other words, the metal underlying layer 3 and the conductive carbon layer 4 are formed on the substrate film 2 in this order toward one side.

In this manner, an electrode 1 including the substrate film 2, the metal underlying layer 3, and the conductive carbon layer 4 is produced.

1.5 Use of Electrode 1

The use of the electrode 1 is not especially limited. Examples of the use of the electrode 1 include electrodes for electrochemical measurements and battery electrodes. Preferably, the use of the electrode 1 is electrodes for electrochemical measurements. Specifically, an electrode 1 is included as a working electrode in an electrochemical measurement system.

2. Operations and Effects of One Embodiment

In the electrode 1 and electrochemical measurement system of the present embodiment, the ratio R of the oxygen in the metal underlying layer 3 is 32% or less in terms of atom, and thus the metal underlying layer 3 has excellent adhesiveness. Specifically, the conductive carbon layer 4 has high adhesive strength to the substrate film 2.

3. Variations

In each variation below, the same members and steps as in the above-described one embodiment are given the same numerical references, and the detailed descriptions thereof are omitted. Furthermore, each of the variations can have the same operations and effects as those of one embodiment unless especially described otherwise. Furthermore, one embodiment and the variations can appropriately be combined.

In a variation, the apparatus for forming a conductive carbon layer 4 is different from the apparatus for forming a metal underlying layer 3. For example, a first sputtering apparatus is used to form a metal underlying layer 3 on the one-side surface of the substrate film 2. The first sputtering apparatus include a target consisting of titanium. Thereafter, a laminate of the substrate film 2 and the metal underlying layer 3 is set on a second sputtering apparatus. The second sputtering apparatus is used to form a conductive carbon layer 4 on the one-side surface of the metal underlying layer 3. The second sputtering apparatus includes a target consisting of sintered carbon.

However, one embodiment is preferable as compared with the variation. In one embodiment, the metal underlying layer 3 and the conductive carbon layer 4 can be formed by using one common sputtering apparatus.

[Examples]

With reference to Examples and Comparative Examples below, the present invention is more specifically described below. The present invention is not limited to Examples and Comparative Examples in any way. The specific numeral values used in the description below, such as blending ratios (content ratios), physical property values, and parameters, can be replaced with the corresponding blending ratios (content ratios), physical property values, and parameters in the above-described "DESCRIPTION OF THE EMBODIMENT", including the upper limit values (numeral values defined with "or less" or "less than") or the lower limit values (numeral values defined with "or more" or "more than").

Example 1

A PET film having a thickness of 188 $\mu$m was disposed as a substrate film 2 on the film deposition plate of the sputtering apparatus of one embodiment. The first target in the sputtering apparatus consisted of titanium. The second target in the sputtering apparatus consisted of sintered carbon.

Next, by driving the decompression unit, the sputtering chamber was depressurized, and the pressure (the achieved degree of vacuum) reaches $0.3 \times 10^{-3}$ Pa. The time (the vacuum arrival time) from the start of the depressurization to the achieved degree of vacuum was 9 hours.

Subsequently, pre-sputtering was carried out to wash the surface of the first target and the surface of the second target. Subsequently, by using magnetron sputtering in which the electric power was applied to the first target, a metal underlying layer 3 consisting of titanium and having a thickness of 15nm was formed on the one-side surface of the substrate film 2 in the thickness direction. The conditions for the magnetron sputtering are described below.

First target: Titanium
Output: $3.3$ W/cm$^2$
Sputtering Gas: Ar
Pressure of Sputtering Gas: 0.2 Pa

Subsequently, by magnetron sputtering in which the electric power was applied to the second target, a conductive carbon layer 4 having a thickness of 30 nm was formed on a one-side surface of the metal underlying layer 3 in the thickness direction. The conditions for the magnetron sputtering are described below.

Second Target: Sintered Carbon
Output: $3.3$ W/cm$^2$
Sputtering Gas: Ar
Pressure of Sputtering Gas: 0.4Pa

In this manner, an electrode 1 including the substrate film 2, the metal underlying layer 3, and the conductive carbon layer 4 in sequence toward one side in the thickness direction.

Examples 2 to 4 and Comparative Examples 1 and 2

An electrode 1 was produced in the same manner as Example 1. However, the vacuum arrival time, the material (the first target) of the underlying layer, and the achieved degree of vacuum were changed as shown Table 1.

<Evaluations>

1. Ratio R of Oxygen in Metal Underlying Layer 3

Using the depth analysis in ESCA, the oxygen ratio of the metal underlying layer 3 was obtained. In the ESCA, an X-ray source of monochrome Al K$\alpha$ (200 $\mu$m$\Phi$, 15kV, 30W) was used. Furthermore, using an Ar ion gun at an accelerating voltage of 1kV, the composition of the metal underlying layer 3 in the thickness direction was analyzed (depth analysis).

Then, in Examples 1 to 3 and Comparative Example 1, the atomic ratio of the titanium at a point at which the atomic ratio of the titanium is the highest in the metal underlying layer 3 was represented by $X_0$. In Comparative Examples 4 and 2, the atomic ratio of the niobium at a point at which the atomic ratio of the niobium is the highest in the metal underlying layer 3 was represented by $X_0$. The unit of $X_0$ was atomic%.

In the metal underlying layer 3, the atomic ratio of the oxygen at the above-described point was represented by $X_1$. The unit of $X_1$ is atomic%.

$X_0$ and $X_1$ are substituted into the following formula (1), the ratio R of the oxygen was obtained in terms of atom.

$$R = 100 \times [X_1/(X_0+X_1)] \quad (1)$$

The results are shown in Table 1.

2. Adhesiveness

11 lines of scratches were made in the shape of a cross in a longitudinal direction and a lateral direction at intervals of 2mm on the conductive carbon layer 4 and the metal underlying layer 3. The longitudinal direction and lateral direction were included in the plane direction of the electrode 1. The lateral direction was perpendicular to the longitudinal direction.

In this manner, a grid of 100 squares was created. In the formation of the grid, a cutter was used.

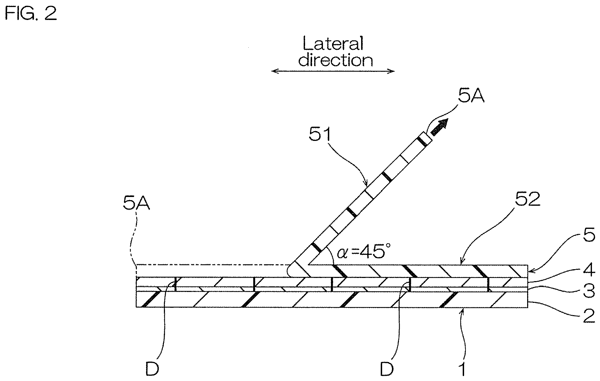

Subsequently, as shown in FIG. 2, a pressure-sensitive adhesive tape (SPV-S-400 manufactured by Nitto Denko Corporation) 5 was strongly compressively bonded to the above-described grid. Next, the electrode 1 and the pressure-sensitive adhesive tape 5 were left to stand under the conditions of 85°C and 85 RH% for one hour. Thereafter, the pressure-sensitive adhesive tape 5 was quickly peeled from the conductive carbon layer 4 at a peeling angle α of 45 degrees. In the above-described peeling, one end portion 5A of the pressure-sensitive adhesive tape 5 in the lateral direction was pulled toward the other side. The angle between the peeled pressure-sensitive adhesive tape 51 including one end portion 1A and the unpeeled pressure-sensitive adhesive tape 52 that was still bonded to the grid corresponded to the peeling angle α (= 45 degrees).

Then, the number of the squares peeled from the substrate film 2 in the grid of 100 squares of the conductive carbon layer 4 were counted. The results were shown in Table 1.

[Table 1]

Table 1

|  | Achieved degree of vacuum | Vacuum arrival time | Metal underlying layer | Evaluations | |
|---|---|---|---|---|---|
|  | (Pa) | (Time) | (Material) | Ratio of oxygen in metal underlying layer (in terms of atom)(%) | Adhesiveness (the number of peeled squares) |
| Example 1 | $0.3 \times 10^{-3}$ | 9 | Titanium | 12 | 0/100 |
| Example 2 | $0.5 \times 10^{-3}$ | 3.5 | Titanium | 24 | 4/100 |
| Example 3 | $0.8 \times 10^{-3}$ | 3 | Titanium | 29 | 10/100 |
| Comparative Example 1 | $2.1 \times 10^{-3}$ | 1.5 | Titanium | 36 | 53/100 |
| Example 4 | $1.0 \times 10^{-4}$ | 3 | Niobium | 10 | 0/100 |
| Comparative Example 2 | $2.0 \times 10^{-3}$ | 1.5 | Niobium | 41 | 61/100 |

While the illustrative embodiments of the present invention are provided in the above description, such is for illustrative purpose only and it is not to be construed as limiting in any manner. Modification and variation of the present invention that will be obvious to those skilled in the art is to be covered by the following claims.

Industrial Applicability

The electrode is used, for example, for an electrochemical measurement.

Description of Reference Numerals

1    electrode
2    substrate film
3    metal underlying layer
4    conductive carbon layer
R    ratio of the oxygen in terms of atom
$X_0$    atomic ratio (atomic%) of the metal material
$X_1$    atomic ratio (atomic%) of the oxygen

**Claims**

1. An electrode comprising: a substrate film; a metal underlying layer; and a conductive carbon layer in sequence toward one side in a thickness direction,

wherein a ratio R of oxygen in the metal underlying layer is 32% or less in terms of atom, and obtained by the following formula (1).

$$R = 100 \times [X_1/(X_0+X_1)] \quad (1)$$

$X_1$: an atomic ratio (atomic%) of oxygen in the metal underlying layer
$X_0$: an atomic ratio (atomic%) of a metal material in the metal underlying layer

2. The electrode according to claim 1, wherein the metal material in the metal underlying layer includes at least one metal selected from the group consisting of titanium, chromium, tungsten, aluminum, silicon, niobium, molybdenum, tantalum, and copper.

3. The electrode according to claim 1 or 2, wherein the substrate film is a polymer film.

4. The electrode according to claim 1 or 2, wherein the conductive carbon layer includes an $sp^2$-bonded atom and an $sp^3$-bonded atom.

5. The electrode according to claim 1, being an electrode for an electrochemical measurement.

6. An electrochemical measurement system comprising: the electrode according to claim 5.

FIG. 1

Plane
direction

One side

Thickness
direction

The other
side

4

3

2

<u>1</u>

FIG. 2

## INTERNATIONAL SEARCH REPORT

| | International application No. |
|---|---|
| | **PCT/JP2023/012755** |

| A. | CLASSIFICATION OF SUBJECT MATTER |
|---|---|

***G01N 27/30***(2006.01)i; ***C23C 14/06***(2006.01)i
FI:  G01N27/30 B; C23C14/06 N

According to International Patent Classification (IPC) or to both national classification and IPC

| B. | FIELDS SEARCHED |
|---|---|

Minimum documentation searched (classification system followed by classification symbols)

G01N27/30; C23C14/06

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

JSTPlus/JMEDPlus/JST7580 (JDreamIII); Scopus

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP 2019-105637 A (NITTO DENKO CORP.) 27 June 2019 (2019-06-27) paragraphs [0008], [0009], [0024], [0029], [0032], [0037], [0040], [0041], [0048], [0049], [0100]-[0102], [0109], fig. 1, table 1 | 1-5 |
| Y | | 1-5 |
| Y | JP 2014-22250 A (KOBE STEEL, LTD.) 03 February 2014 (2014-02-03) paragraphs [0009], [0013], [0015], [0019], [0020], [0023], [0026], [0028], [0043], [0051], [0052], fig. 1 | 1-5 |
| A | WO 2016/013478 A1 (TOYOBO CO., LTD.) 28 January 2016 (2016-01-28) entire text, all drawings | 1-5 |
| A | WO 2010/004690 A1 (NEC CORP.) 14 January 2010 (2010-01-14) entire text, all drawings | 1-5 |
| A | JP 2006-78375 A (MATSUSHITA ELECTRIC IND. CO., LTD.) 23 March 2006 (2006-03-23) entire text, all drawings | 1-5 |

✔ Further documents are listed in the continuation of Box C.    ✔ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **15 May 2023** | **30 May 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

| International application No. |
|---|
| **PCT/JP2023/012755** |

**C.    DOCUMENTS CONSIDERED TO BE RELEVANT**

| Category* | Citation of document, with indication, where appropriate, of the relevant passages | Relevant to claim No. |
|---|---|---|
| A | LOWE, M. A. et al. Formation of a Crack-Free and Debonding-Resistant Boron-Doped Diamond Thin Film on Titanium Using a Dual-Coating Strategy. J. Electrochem. Soc. 2006, vol. 153, no. 11, pp. B506-B511, DOI 10.1149/1.2349493, ISSN 1452-3981<br>entire text, all drawings | 1-5 |
| A | PROTOPOPOVA, V. et al., Ultrathin undoped tetrahedral amorphous carbon films: The role of the underlying titanium layer on the electronic structure, Diamond & Related Materials, 2015, vol. 57, pp. 43-52, https://doi.org/10.1016/j.diamond.2015.06.009, ISSN 0925-9635<br>entire text, all drawings | 1-5 |

Form PCT/ISA/210 (second sheet) (January 2015)

## INTERNATIONAL SEARCH REPORT
### Information on patent family members

International application No.

**PCT/JP2023/012755**

| Patent document cited in search report | | | Publication date (day/month/year) | Patent family member(s) | Publication date (day/month/year) |
|---|---|---|---|---|---|
| JP | 2019-105637 | A | 27 June 2019 | US 2021/0172897 A1 paragraphs [0008], [0009], [0024], [0029], [0032], [0037], [0040], [0041], [0048], [0049], [0100]-[0102], [0110], fig. 1, table 1 <br> WO 2019/117112 A1 <br> EP 3726207 A1 <br> CN 111373248 A | |
| JP | 2014-22250 | A | 03 February 2014 | US 2015/0171434 A1 paragraphs [0009], [0018], [0020], [0027]-[0030], [0033], [0034], [0037], [0038], [0040], [0059], [0060], [0071], [0072], fig. 1 <br> WO 2014/013859 A1 <br> CN 104471768 A <br> KR 10-2015-0030230 A | |
| WO | 2016/013478 | A1 | 28 January 2016 | US 2017/0153200 A1 entire text, all drawings <br> KR 10-2017-0036707 A | |
| WO | 2010/004690 | A1 | 14 January 2010 | (Family: none) | |
| JP | 2006-78375 | A | 23 March 2006 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2019105637 A